Europäisches Patentamt

European Patent Office

Office européen des brevets

(11) Veröffentlichungsnummer: **0 387 660**
**A1**

# (12) EUROPÄISCHE PATENTANMELDUNG

(21) Anmeldenummer: **90104232.5**

(22) Anmeldetag: **06.03.90**

(51) Int. Cl.5: **B23D 59/00, H01L 21/00, G01D 5/20**

(30) Priorität: **07.03.89 DE 3907321**

(43) Veröffentlichungstag der Anmeldung:
**19.09.90 Patentblatt 90/38**

(84) Benannte Vertragsstaaten:
**CH DE FR GB IT LI**

(71) Anmelder: **Wacker-Chemitronic Gesellschaft für Elektronik-Grundstoffe mbH Johannes-Hess-Strasse 24 D-8263 Burghausen(DE)**

(72) Erfinder: **Seeburger, Helmut, Dipl.-Ing. (FH) Robert-Koch-Strasse 152 D-8263 Burghausen(DE)**

(54) **Verfahren zur Überwachung des Schnittverlaufes beim Innenlochsägen von Halbleitermaterial und Wirbelstromsensor zu seiner Durchführung.**

(57) Herkömmliche Wirbelstromsensoren liefern bei der Überwachung des Schnittverlaufes beim Innenlochsägen von Halbleiterstäben zuweilen falsche Meßwerte, vermutlich wegen Störungen durch das unvermeidliche Kühlschmiermittel, welches in den Sägespalt eingespeist wird. Solche Probleme können erfindungsgemäß verhindert werden, wenn die Sensoren mit einer Abdeckung aus Halbleitermaterial, insbesondere Silicium versehen werden. Diese Sensoren liefern zuverlässige Meßwerte und können daher auch bei weitgehend automatisierten Sägeverfahren eingesetzt werden.

EP 0 387 660 A1

Xerox Copy Centre

# Verfahren zur Überwachung des Schnittverlaufes beim Innenlochsägen von Halbleitermaterial und Wirbelstromsensor zu seiner Durchführung.

Die Erfindung betrifft ein Verfahren zur Überwachung des Schnittverlaufes beim Innenlochsägen von Halbleitermaterial, insbesondere Silicium, in Scheiben, bei dem zumindest ein in einer festen Position bezüglich des Sägeblattes befindlicher Wirbelstromsensor eingesetzt wird.

Für das Zersägen von Stäben oder Blöcken aus Halbleitermaterial, insbesondere Silicium, in dünne Scheiben von typisch 0.1 bis 1 mm Dicke werden in erster Linie Innenlochsägen eingesetzt, da sich mit ihnen am besten die hohen Anforderungen an die geometrische Qualität der Scheiben erfüllen lassen. Allerdings zeigt auch bei solchen Innenlochsägen im Verlauf des Sägevorganges das Sägeblatt mit seiner den eigentlichen Materialabtrag bewirkenden Schneidkante, gewöhnlich einer das Innenloch umgebenden Matrix aus Metall wie z.B. Nickel, in welche Körner aus Hartstoffen wie etwa Diamant eingebettet sind, auf seinem Weg durch das Werkstück Abweichungen von der erwünschten Schnittlinie. Infolgedessen weisen manche der erhaltenen Scheiben in mehr oder minder großem Maße geometrische Fehler wie Dickenvariation, Krümmung ("warp") oder Biegung ("bow") auf. Bei den ständig steigenden Anforderungen der Hersteller elektronischer Bauelemente an die Scheibengeometrie führt dies dazu, daß immer mehr Scheiben aufgrund geometrischer Mängel von der Weiterverarbeitung ausgeschlossen werden müssen.

Um solche Verluste zu vermeiden, werden in verstärktem Maße Verfahren eingesetzt, bei denen während des Sägevorganges diese genannte Abweichung des Sägeblattes von der gewünschten Sollschnittlinie ausgeglichen werden kann, beispielsweise indem regulierende Kräfte auf das Sägeblatt ausgeübt werden. Voraussetzung dafür ist aber, daß leistungsfähige Verfahren zur Verfügung stehen, die bei jedem Sägevorgang die Überwachung des Schnittverlaufes mit hoher Genauigkeit ermöglichen.

Derzeit werden zu diesem Zweck hauptsächlich Wirbelstromsensoren eingesetzt. Das zugrundeliegende Meßprinzip besteht darin, daß der Sensor mittels einer von einem hochfrequenten Wechselstrom durchflossenen Spule im Sägeblatt der Innenlochsäge Wirbelströme induziert, die ihrerseits im Sensor in Abhängigkeit vom Abstand Sensor/Sägeblatt Impedanzänderungen hervorrufen, aus denen sich letztlich eine diesem Abstand proportionale Spannungsänderung ableiten läßt. Üblicherweise werden einer oder mehrere Sensoren in einer festen Position bezüglich des Sägeblattes installiert und registrieren die während des Sägens auftretenden Abstandsänderungen zum Sägeblatt, die ggf. über eine Steuereinheit in Regelimpulse zum Ausgleich der Abweichungen umgesetzt werden können.

Nachteilig ist bei diesen Überwachungsverfahren mit herkömmlichen Wirbelstromsensoren ihre Störungsanfälligkeit gegenüber dem beim Innenlochsägen unverzichtbaren Kühlschmiermittel, in den meisten Fällen tensidhaltigem Wasser. Dieses wird beim Sägevorgang in den Sägespalt eingespeist und dabei in wechselnden Mengen vom Sägeblatt mitgerissen, wobei es sich auch mehr oder weniger stark über dessen Seitenflächen verteilt, was zu einer beträchtlichen Verfälschung der erfaßten Abstandswerte führen kann. Dieser störende Effekt kommt besonders in den eigentlich am besten für die Überwachung geeigneten Positionen der Sensoren zum Tragen, nämlich wenn der Schnittverlauf durch die entstehende Scheibe hindurch verfolgt werden soll. In diesem Fall werden mit den herkömmlichen Sensoren keine verläßlichen Meßwerte mehr erhalten. Dies ist besonders nachteilig, wenn aufgrund dieser Werte Regel- oder Korrekturmaßnahmen am Sägeblatt oder Werkstück vorgenommen werden, was vor allem bei automatisierten Prozessen zu schwerwiegenden Fehlern und Störungen führen kann.

Aufgabe der Erfindung war es daher, ein Verfahren anzugeben, welches die genannten Störungen vermeidet und es insbesondere gestattet, das Sägeblatt auf seinem Weg innerhalb des Werkstükkes durch die entstehende Scheibe hindurch zu überwachen. Aufgabe war es weiterhin, zur Durchführung des Verfahrens geeignete Wirbelstromsensoren zur Verfügung zu stellen, die sich insbesondere auch zum Einsatz in automatisierten Prozessen eignen.

Gelöst wird die Aufgabe durch ein Verfahren, welches gekennzeichnet ist durch den Einsatz eines oder mehrerer Sensoren, die an der dem Sägeblatt zugewandten Seite mit einer Abdeckung aus Halbleitermaterial versehen sind.

Überraschend wurde nämlich gefunden, daß bei mit einer derartigen Abdeckung versehenen Sensoren die zur Überwachung des Schnittverlaufes dienenden Meßergebnisse nicht mehr durch Wasser und/oder Kühlschmiermittel beeinflußt und verfälscht werden.

Als Halbleitermaterial für die Abdeckung wird bevorzugt Silicium verwendet, wenngleich grundsätzlich auch andere Materialien auf Basis von Element- oder Verbindungshalbleitern wie beispielsweise Germanium, Galliumarsenid, Indiumphosphid oder Cadmiumtellurid geeignet sind. Vorteilhaft wird das Material in hochdotierter Form eingesetzt, wobei sich ein Bereich des spezifischen Widerstands von bis zu etwa 35 Ωcm, bevorzugt 0.01 bis 30 Ωcm bewährt hat, und zwar insbesondere bei Abdeckungen aus Silicium. Dabei kann das Material sowohl eine p-Dotierung als auch eine n-Dotierung aufweisen. So ist beispielsweise mit Bor oder mit Phosphor dotiertes Silicium gleichermaßen gut geeignet. Bevorzugt wird auf in einkristalliner Form vorliegende Halbleiter zurückgegriffen, wenngleich dies nicht zwingend vorgeschrieben ist und grundsätzlich auch multi- oder polykristalline Stoffe, die sich aus entsprechend größeren oder kleineren Kristalliten zusammensetzten, verwendet werden können.

Gute Ergebnisse wurden mit Abdeckungen erzielt, deren Dicke zwischen 100 und 1000 μm liegt und vorteilhaft 200 bis 500 μm beträgt und möglichst gleichmäßig ist. Dieser Dickenbereich ist bei den in der Halbleitertechnologie z.B. zur Herstellung von Solarzellen oder hochintegrierten Bauelementen verwendeten Scheiben gebräuchlich, die gleichzeitig nur eine geringe Dickenvariation aufweisen. Zweckmäßig werden daher solche Scheiben auch als Ausgangsmaterial für die Abdeckung eingesetzt, wobei gegebenenfalls die Größe durch eine formgebende Bearbeitung wie etwa Schleifen oder Sägen den Maßen der abzudeckenden Sensorfläche angepaßt werden muß. Geeignet sind Scheiben insbesondere mit ein- oder beidseitig polierter, aber auch gesägter, geläppter, geschliffener oder geätzter Oberfläche. Die genannten Dickenbereiche sind jedoch nicht zwingend vorgeschrieben; es ist grundsätzlich auch möglich, gegenüber den genannten Bereichen dünnere oder dickere Abdeckungen einzusetzen, wobei die mögliche Untergrenze durch die mechanische Stabilität, die mögliche Obergrenze durch den Wirkungsbereich des Sensors vorgegeben ist. Grundsätzlich denkbar ist auch die Verwendung von Abdeckungen, deren Oberflächen nicht planparallel, sondern beispielsweise keilig, konkav oder konvex ausgebildet sind.

Ein Vorteil der Erfindung liegt darin, daß sich die bekannten und beispielsweise im Handel erhältlichen Wirbelstromsensoren leicht entsprechend umrüsten lassen. Zu diesem Zweck braucht lediglich die vorgesehene Abdeckung auf der dem Meßobjekt zugewandten Seite des Sensors befestigt, beispielsweise angeklebt, angeklemmt oder angeschraubt zu werden. Zweckmäßig wird dabei die Abdeckung direkt auf die üblicherweise die eigentliche Sensorspule bedeckende Isolierschicht aufgebracht, wobei jedoch grundsätzlich auch ein freier Spalt zwischen Abdeckung und Spule vorgesehen sein kann. Günstig werden Sensoren in gekapselter Ausführung verwendet, die beispielsweise auf ihren dem Meßobjekt abgewandten Seiten mit einer Ummantelung z.B. aus Kunststoff versehen sind, da sie erfahrungsgemäß besonders robust und störungsunempfindlich sind. Als vorteilhaft hat es sich auch erwiesen, wenn der Durchmesser der Abdeckung größer ist als der der Sensorspule, so daß der Rand der befestigten Abdeckung über den Spulenrand hinausragt, wobei Spule und Abdeckung vorzugsweise konzentrisch angeordnet sind. Bewährt haben sich dabei insbesondere dem 1.01- bis 2.5-fachen Spulendurchmesser entsprechende Werte. Es wurde gefunden, daß diese Ausgestaltung eine besonders günstige und wenig störungsanfällige Ausformung des elektromagnetischen Wechselfeldes zur Folge hat. Besonders gute Ergebnisse können auch dadurch erzielt werden, daß die Abdeckung mit dem Sensor masseschlüssig verbunden wird, was beispielsweise durch direkten oder über leitfähige Klebstoffe hergestellten elektrischen Kontakt mit der metallischen Sensorfassung erreicht werden kann, oder auch über andere elektrisch leitende Verbindungen.

Für den eigentlichen Einsatz bei der Überwachung des Schnittverlaufes werden die solcherart mit einer Abdeckung aus Halbleitermaterial versehenen Sensoren in der bekannten Weise in einer festen Position bezüglich des Meßobjektes, also des Sägeblattes, angebracht und justiert. Auslenkbewegungen des Sägeblattes führen dann zu einer Änderung seines Abstandes zum Sensor, und können von diesem in entsprechende Meßsignale umgesetzt werden. Diese Position kann beispielsweise so gewählt sein, daß der oder die Sensoren während des Sägevorganges sich neben dem Werkstück befinden, so daß die Lage des Sägeblattes vor seinem Eintritt in den Sägespalt und/oder nach seinem Austritt aus demselben überwacht und daraus indirekt auf den Schnittverlauf im Werkstück geschlossen wird.

Die Vorteile der erfindungsgemäßen Sensoren kommen jedoch in besonderem Maße zum Tragen, wenn in der bevorzugten Weise die feste Position so gewählt wird, daß der Schnittverlauf zumindest teilweise durch die entstehende Scheibe hindurch überwacht wird. Als besonders geeignet hat sich eine Position im Scheitelbereich des Innenloches des Sägeblattes erwiesen, d.h. eine Position, von der aus beim Sägevorgang ein möglichst großer Bereich der entstehenden Scheibe vom Sensor überstrichen wird. Günstig wird dabei der Sensor so justiert, daß die Schneidkante und der untere Rand der Sensorspule sich auf gleicher Höhe befinden, wobei es in der Regel ausreichend ist, wenn die Justierung mit bloßem Auge vorgenommen wird, wodurch sich erfahrungsgemäß eine Übereinstimmung auf ca. ± 0.1 mm erzielen läßt. Grundsätzlich können die Sensoren jedoch auch in Positionen angeordnet sein, die demgegenüber näher beim Außenrand des Sägeblattes liegen. Gleichfalls nicht ausgeschlossen sind Anordnungen, bei denen der Sensor teilweise in den Innenlochbereich hineinragt, wobei meist noch befriedigende Ergebnisse erhalten werden, wenn dieser Anteil etwa 30 % der dem Sägeblatt zugewandten Sensorfläche nicht übersteigt.

Günstig werden die Sensoren so justiert, daß ihre Abdeckung möglichst parallel zum Sägeblatt ausgerichtet ist, wobei die Justierung zweckmäßig bei ruhendem oder ungestört und frei rotierendem Sägeblatt vorgenommen wird. Die zuverlässigsten Betriebsergebnisse werden erzielt, wenn in der Arbeitsposition der Spalt zwischen der Abdeckung des Sensors und dem Sägeblatt zumindest der zweifachen Scheibendicke entspricht und innerhalb des je nach Sensortyp verschiedenen optimalen Wirkungsbereiches liegt. Bei höheren Spaltdicken im Grenzbereich der üblichen Sensorreichweiten werden in der Regel die Meßsignale für eine zuverlässige Auswertung zu schwach, während bei geringeren Spaltdicken die Gefahr besteht, daß der Sensor bei fehlerhafter Zustellung des Werkstückes in die Schnittposition oder bei Schnittfehlern beschädigt, verschoben oder dejustiert wird. Grundsätzlich kann jedoch der Minimalabstand bis auf Werte verringert werden, die nur geringfügig größer sind als die vorgesehene Scheibendicke, und auch Maximalabstände bis zur Grenze des Wirkungsbereichs des jeweiligen Sensors sind nicht ausgeschlossen.

Beim eigentlichen Sägevorgang kann dann in der bekannten Weise von dem zu zersägenden Werkstück Scheibe für Scheibe abgetrennt werden, wobei mit Hilfe des erfindungsgemäßen Sensors die auftretende Auslenkung des Sägeblattes mit hoher Genauigkeit - es konnten bereits Auflösungen bis in den Bereich von ± 1 μm erzielt werden - erfaßt und verfolgt werden kann. Die dabei ermittelten Werte können als Regelgrößen zur Grundlage von der Auslenkung entgegenwirkenden Maßnahmen gemacht werden, wie beispielsweise Schärfeingriffen an der Schneidkante oder Veränderungen der axial am Sägeblatt angreifenden Kräfte im Sägespalt.

Das Verfahren eignet sich insbesondere zum Einsatz beim Innenlochsägen von stab- oder blockförmigen Werkstücken aus hochohmigem, aber auch niederohmigem Silicium. Es kann gleichermaßen bei anderen Elementhalbleitern wie Germanium oder bei Verbindungshalbleitern wie Galliumarsenid, Indiumphosphid, Cadmiumtellurid oder Kupfer-Indium-Selenid angewendet werden. Die Vorteile zeigen sich vor allem beim Zersägen von Stäben mit großen Durchmessern von mehr als ca. 10 cm in Scheiben von hoher geometrischer Qualität, da der Lauf des Sägeblattes sehr genau verfolgt werden kann und somit regelnde Eingriffe frühzeitig erfolgen können. Ein besonders günstiger Einsatzbereich sind Sägeverfahren, bei denen es auf eine genaue Überwachung des Sägeblattes und zuverlässige Meßwerte ankommt, wie z.B. Verfahren, bei denen über eine Rechnersteuerung die erfaßten Abweichungen des Sägeblattes ausgeglichen werden.

Nachstehend wird das Verfahren sowie ein zu seiner Durchführung geeigneter Sensor an Hand eines Ausführungsbeispiels näher erläutert:

Ausführungsbeispiel:

Ein handelsüblicher Wirbelstromsensor (Hersteller: Fa. Mikroepsilon), der aus einer mit Zuleitungen versehenen, in eine Kunststoffgießmasse eingebetteten zweiadrigen Kupferspule bestand, welche von einer Metallfassung und einer Ummantelung aus Polyvinylchlorid umgeben war, wobei die freie, kreisförmige ebene Stirnfläche (Durchmesser ca. 2.5 cm) bei der Messung dem jeweiligen Meßobjekt zugewandt war, wurde in der erfindungsgemäßen Weise umgerüstet. Zu diesem Zweck wurde zunächst aus einer ca. 400 μm dikken Scheibe aus p-dotiertem, einkristallinem Silicium (spezifischer Widerstand ca. 0.1 Ωcm, (100)-Orientierung, Scheibendurchmesser ca. 10 cm), deren Oberfläche nach dem Sägen noch geätzt worden war, eine Scheibe mit etwa 3 cm Durchmesser herausgebohrt. Diese Scheibe wurde nun mittels eines wasserfesten elektrisch leitfähigen Klebstoffes konzentrisch zur Spule auf die Stirnfläche des Sensors aufgeklebt, wobei der durch die Gießmasse vollständig ausgefüllte Spalt zwischen Spule und Abdeckung ca. 0.1 mm betrug, während durch Kontakt mit der Metallfassung der Masseschluß bezüglich des Sensors hergestellt war.

Der solcherart vorbereitete Sensor wurde nun in einer handelsüblichen Innenlochsäge mit Hilfe einer geeigneten verstellbaren Halterung in der vorgesehenen Meßposition angebracht. Diese wurde so gewählt, daß der untere Rand der Abdeckung sich auf gleicher Höhe mit der Schneidkante des Innenlochsägeblattes befand. Die abgedeckte Stirnfläche wurde möglichst parallel zur Seitenfläche des Sägeblattes ausge-richtet; der Abstand wurde auf ca. 3.5 mm eingestellt. Die Ausrichtung wurde visuell kontrolliert. Aus der gewählten Meßposition konnte beim Sägevorgang der Lauf des Sägeblattes durch die entstehende Scheibe hindurch überwacht werden, wobei der überstrichene Meßbereich synchron zur Schnittbewegung jeweils von der Scheitelhöhe des Werkstückes durch die Mitte bis zur Basisrundung verlief.

Die mit dem erfindungsgemäßen Sensor bestückte Innenlochsäge wurde nun zum Zersägen von Siliciumstäben (Durchmesser ca. 15 cm, Länge ca. 40 cm, spezifischer Widerstand ca. 10 Ωcm) in Scheiben von ca. 800 μm Dicke eingesetzt. Der

eigentliche Sägevorgang wurde dabei in der üblichen Art und Weise unter Zugabe eines Kühlschmiermittels in die Schneidzone und periodischem Nachschärfen des Sägeblattes durchgeführt, wobei der Schnittverlauf bei jeder Scheibe mit Hilfe des Sensors überwacht wurde und jede Abweichung des Sägeblattes aus seiner Sollposition registriert und über einen Schreiber aufgezeichnet wurde.

Nach diesem Verfahren wurden, ohne daß eine Störung des Meßvorganges festgestellt werden konnte, etwa 20000 Scheiben gesägt. Die Auswertung der Meßprotokolle ergab, daß der Sensor die Überwachung des Sägeblattes durch die Scheibe hindurch mit hoher Genauigkeit (Auflösung ca. ± 1 $\mu$m) und großer Zuverlässigkeit gestattete und daher auch für Verfahren geeignet war, bei denen die von ihm gelieferten Meßsignale als Grundlage für eine rechnergesteuerte Nachregulierung des Sägeblattes und/oder Werkstückes vorgesehen waren.

In einem Vergleichsversuch wurden mit derselben Innenlochsäge und unter den gleichen Bedingungen weitere 1000 Siliciumscheiben gesägt, wobei in der gleichen Meßposition ein identischer Wirbelstromsensor, jedoch ohne die erfindungsgemäße Abdeckung eingesetzt wurde. Dieser Sensor zeigte bei manchen Sägevorgängen in Wirklichkeit nicht vorhandene Abweichungen des Sägeblattes aus der Sollage von bis zu 20 $\mu$m an. Dieser Sensor war somit für die Überwachung des Schnittverlaufes und insbesondere für den Einsatz bei rechnergesteuerten Sägeverfahren nicht geeignet.

## Ansprüche

1. Verfahren zur Überwachung des Schnittverlaufes beim Innenlochsägen von Halbleitermaterial, insbesondere Silicium, in Scheiben, bei dem zumindest ein in einer festen Position bezüglich des Sägeblattes befindlicher Wirbelstromsensor eingesetzt wird, gekennzeichnet durch den Einsatz eines oder mehrerer Sensoren, die an ihrer dem Sägeblatt zugewandten Seite mit einer Abdeckung aus Halbleitermaterial versehen sind.

2. Verfahren nach Anspruch 1, dadurch gekennzeichnet, daß die feste Position die Überwachung des Schnittverlaufes zumindest teilweise durch die entstehende Scheibe hindurch gestattet.

3. Verfahren nach den Ansprüchen 1 oder 2, dadurch gekennzeichnet, daß der Sensor in einer festen Position mit einem Abstand zur Seitenfläche des Sägeblattes gehalten wird, der größer ist als die vorgesehene Scheibendicke.

4. Verfahren nach einem oder mehreren der Ansprüche 1 bis 3, dadurch gekennzeichnet, daß der Sensor in einer festen Position im Scheitelbereich des Innenloches des Sägeblattes gehalten wird.

5. Wirbelstromsensor zur Durchführung des Verfahrens nach einem oder mehreren der Ansprüche 1 bis 4, gekennzeichnet durch eine Abdeckung aus Halbleitermaterial auf der dem Sägeblatt zugewandten Seite.

6. Wirbelstromsensor nach Anspruch 5, dadurch gekenn zeichnet, daß die Abdeckung eine Dicke von 100 bis 500 $\mu$m aufweist.

7. Wirbelstromsensor nach den Ansprüchen 5 oder 6, dadurch gekennzeichnet, daß die Abdeckung aus Silicium besteht.

8. Wirbelstromsensor nach einem oder mehreren der Ansprüche 5 bis 7, dadurch gekennzeichnet, daß die Abdeckung aus monokristallinem Silicium besteht.

9. Wirbelstromsensor nach einem oder mehreren der Ansprüche 5 bis 8, dadurch gekennzeichnet, daß die Abdeckung aus Silicium einen spezifischen Widerstand von 0.01 bis 30 $\Omega$cm aufweist.

10. Wirbelstromsensor nach einem oder mehreren der Ansprüche 5 bis 9, gekennzeichnet durch eine Kapselung auf den dem Sägeblatt abgewandten Seiten.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | EP-A-0229451 (WACKER-CHEMITRONIC GESELLSCHAFT FUER ELEKTRONIK-GRUNDSTOFFE MBH) * Spalte 1, Zeile 1 - Spalte 2, Zeile 35 * --- | 1-5, 7, 10 | B23D59/00 H01L21/00 G01D5/20 |
| Y | PATENT ABSTRACTS OF JAPAN vol. 181, no. 4 (E-037)() 13 Dezember 1980, & JP-A-55 124271 (MITSUBISHI ELECTRIC CORP) 25 September 1980, * das ganze Dokument * --- | 1-5, 7 | |
| A | PROCEEDINGS OF THE IEEE. vol. 70, no. 5, 05 1982, NEW YORK US Seiten 420 - 457; Kurt E. Petersen: "Silicon as a Mechanical Material" * Seite 421, linke Spalte, letzter Absatz * --- | 8 | |
| Y | DE-A-2637413 (SIEMENS AG) * Ansprüche 1, 4 * ----- | 10 | |

RECHERCHIERTE
SACHGEBIETE (Int. Cl.5 )

B23D
B28D
G01D
H01L

Der vorliegende Recherchenbericht wurde für alle Patentansprüche erstellt

| Recherchenort | Abschlußdatum der Recherche | Prüfer |
|---|---|---|
| DEN HAAG | 03 JULI 1990 | LUT K. |

**KATEGORIE DER GENANNTEN DOKUMENTE**

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus andern Gründen angeführtes Dokument
......................................................................
& : Mitglied der gleichen Patentfamilie, übereinstimmendes
  Dokument

EPO FORM 1503 03.82 (P0403)